# EUROPEAN PATENT SPECIFICATION

(11) **EP 2 381 340 B1**
(45) Date of publication and mention of the grant of the patent: **14.03.2018**
(21) Application number: 11163539.7
(22) Date of filing: 21.04.2011
(51) Int. Cl.: G06F 3/01, G06F 3/041, H01L 41/08

(54) **Transparent piezoelectric combined touch sensor and haptic actuator**
Transparenter zusammengesetzter piezoelektrischer Berührungssensor und haptischer Aktor
Combinaison de capteur tactile et actionneur haptique piézoélectrique transparent

(30) Priority: 23.04.2010 US 327625 P
(43) Date of publication of application: 26.10.2011
(60) Divisional application: 18154466.9
(73) Proprietor: Immersion Corporation, San Jose CA 95134 (US)
(72) Inventor: Modarres, Ali, Mont-Royal Québec H3P 1A5 (CA); Ramstein, Christophe, San Francisco, CA 94019 (US); Cruz-Hernandez, Juan Manuel, Montreal Québec H3Z T1 (CA); Grant, Danny A., Laval Québec H7M 2A1 (CA)
(74) Representative: Beck Greener

(56) References cited:
- EP-A1- 2 112 576
- US-A1- 2006 028 095
- US-A1- 2008 303 782
- US-A1- 2009 002 328
- US-A1- 2009 167 704
- US-A1- 2010 052 880
- US-B1- 7 245 292
- US-B2- 7 113 177

## Description

The present invention is related to a haptic device that includes a transparent composite piezoelectric combined touch sensor and haptic actuator.

Electronic device manufacturers strive to produce a rich interface for users. Conventional electronic devices often provide visual and/or auditory feedback to communicate information to users. In some cases, kinesthetic feedback (such as active and resistive force feedback) and/or tactile feedback (such as vibration, texture, and heat) may also be provided to the user to enhance the user experience. Generally speaking, kinesthetic feedback and tactile feedback are collectively known as "haptic feedback" or "haptic effects." Haptic feedback may be useful for providing cues to alert the user of specific events or to provide realistic feedback sensations to create a greater sensory experience. Haptic feedback can be used with common electronic devices and even devices used for creating a simulated or virtual environment.

Various haptic actuation technologies have been used in the past to provide vibrotactile haptic feedback to touch sensitive devices, such as touch screens. Known haptic feedback devices use electric actuators, such as Linear Resonant Actuator ("LRA") devices and Eccentric Rotating Mass ("ERM") devices. However, these actuators are generally not scalable and do not always performance sufficiently in haptic applications. These devices are often very bulky and can have difficulty meeting certain space limitations.

Another conventional haptic feedback technology in touch sensitive devices is electro-active polymer ("EAP") devices. One drawback of this technology, however, is that EAP-based actuators normally require thousands of volts of electricity to provide effects that are suitable for haptic applications.

Development of haptic feedback structures has led to smaller, more compact devices. Hence, another line of technologies for providing haptic feedback in touch sensitive devices is monolithic piezoelectric ceramics. Actuators made from these ceramics, referred to as monolithic piezoelectric actuators, offer satisfactory solutions for haptic feedback because of their scalability and fast dynamics. However, the mechanical integration and mounting of such actuators into consumer products can often be troublesome. Also, monolithic piezoelectric ceramics are normally quite fragile and brittle and can break if the electronic device incorporating the ceramics is dropped or if it experiences other similar forces or stresses. It can be difficult at times to integrate monolithic piezoelectric ceramics into commercialized products.

For these haptic feedback devices, a separate touch sensor is used to sense whether a haptic feedback effect should be initiated.

EP-A-2112576 discloses a system and method for generating a feedback signal in response to an input signal. The transducer comprises a fibre layer which acts as a combined sensor and actuator. US-A-2008/0303782 discloses a method and apparatus for an electronic interactive device having a haptic enables flexible touch sensitive surface. US-A-2009/002328 discloses a method and apparatus for actuator mechanisms for a multi-touch tactile touch panel. The tactile touch panel includes an electrical insulated layer and a tactile layer.

In embodiments, transparent composite piezoelectric technology is used to create a transparent composite piezoelectric combined touch sensor and haptic actuator that may be used in a haptic device, such as a touch screen.

In an embodiment, there is provided a haptic device that includes a substrate, and a substantially transparent composite piezoelectric cell overlaying the substrate. The piezoelectric cell includes a sensor piezoelectric layer configured to generate a first signal when the sensor piezoelectric layer is deformed, and an actuator piezoelectric layer configured to provide a haptic effect upon receipt of a second signal that is based on the first signal.

According to a first aspect of the present invention, there is provided a haptic device, comprising: a substrate; and a substantially transparent composite piezoelectric cell overlaying the substrate, the piezoelectric cell comprising a sensor piezoelectric layer configured to generate a first signal when the sensor piezoelectric layer is deformed, and an actuator piezoelectric layer configured to provide a haptic effect upon receipt of a second signal that is based on the first signal.

In one embodiment, the sensor piezoelectric layer overlays the actuator piezoelectric layer. In one embodiment, the actuator piezoelectric layer overlays the sensor piezoelectric layer. In one embodiment, the substrate is configured to display an image, and wherein the image is viewable through the substantially transparent composite piezoelectric cell. In one embodiment, the haptic device includes a plurality of substantially transparent composite piezoelectric cells overlaying the substrate.

In one embodiment, the haptic device includes a vibration isolator located between adjacent piezoelectric cells and configured to isolate vibration in one of the piezoelectric cells from other piezoelectric cells. In one embodiment, the vibration isolator comprises a polymer. In one embodiment, the vibration isolator comprises a gap between the cells. In one embodiment, the substrate and the substantially transparent composite piezoelectric cell are flexible and configured for gross deformations.

In one embodiment, there is provided a haptic device that includes a substantially transparent composite piezoelectric cell configured to measure a deformation of a surface of the cell and to provide a haptic effect as a result of the deformation. The cell includes a first electrode, a second electrode, and a plurality of piezo ceramic materials in between the first electrode and the second electrode. When an electric field is created between the first electrode and the second electrode, the piezo ceramic materials actuate to provide the haptic effect.

According to a second aspect of the present invention, there is provided a haptic device, comprising a substantially transparent composite piezoelectric cell configured to measure a deformation of a surface of the cell and to provide a haptic effect as a result of the deformation, the cell comprising a first electrode, a second electrode, and a plurality of piezo ceramic materials in between the first electrode and the second electrode, wherein when an electric field is created between the first electrode and the second electrode, the piezo ceramic materials actuate to provide the haptic effect.

In one embodiment, the haptic device includes a display configured to display an image, wherein the substantially transparent composite piezoelectric cell overlays the display so that the image is visible through the substantially transparent composite piezoelectric cell.

In one embodiment, the haptic device includes a plurality of substantially transparent composite piezoelectric cells.

In one embodiment, the haptic device includes a vibration isolator located between adjacent piezoelectric cells and configured to isolate vibration in one of the piezoelectric cells from other piezoelectric cells.

In one embodiment, the substantially transparent composite piezoelectric cell is flexible and configured for gross deformations.

According to a third aspect of the present invention, there is provided a haptic device comprising a substantially transparent piezoelectric sensor layer comprising an array of sensor cells, a substantially transparent piezoelectric actuator layer comprising an array of independently actuatable actuator cells, and a display configured to display an image viewable through the substantially transparent piezoelectric sensor layer and the substantially transparent piezoelectric actuator layer.

In one embodiment, the array of sensor cells includes more cells than the array of actuator cells.

In one embodiment, the haptic device includes a second substantially transparent piezoelectric actuator layer comprising a second array of independently actuatable actuator cells.

In one embodiment, the array of sensor cells includes more cells than the second array of actuator cells.

In one embodiment, the display, the substantially transparent piezoelectric sensor layer, and the substantially transparent piezoelectric actuator layer are flexible and configured for gross deformations.

In one embodiment, the substantially transparent piezoelectric actuator layer overlays the display and the substantially transparent piezoelectric sensor layer overlays the substantially transparent piezoelectric actuator layer.

In one embodiment, the substantially transparent piezoelectric sensor layer overlays the display and the substantially transparent piezoelectric actuator layer overlays the substantially transparent piezoelectric sensor layer.

In one embodiment, a plurality of combined touch sensor and haptic actuator cells may be used in the form of a grid of rectangular or circular (or other geometries) cells to create a touch screen/touch pad device which at the same time is capable of providing isolated local haptic feedback.

The sensor and actuator functionality may be achieved by a single module, which may lead to a thinner, more compact solution with simpler integration methods, as compared to the traditional alternatives. The composite piezoelectric sensor/actuator may be made in various form factors (scalability), thereby making it suitable for different applications. Composite piezo materials may be optimized to achieve specific electromechanical properties tailored for each application. The touch sensors according to embodiments of the present invention may be used not only to detect touch, but also to measure the magnitude of the input pressure. In addition, a wide range of rich haptic effects, such as vibrotactile or kinesthetic effects and/or static or dynamic deformations, may be achieved with embodiments of the present invention, due to the fast dynamics and the excellent actuation performance of the composite piezo material.

The embodiments described in the present disclosure may include various features and advantages, which may not necessarily be expressly disclosed herein but will be apparent to one of ordinary skill in the art upon examination of the following detailed description and accompanying drawings.

The components of the following figures are illustrated to emphasize the general principles of the present disclosure and are not necessarily drawn to scale. Reference characters designating corresponding components are repeated as necessary throughout the figures for the sake of consistency and clarity.

Embodiments of the present invention will now be described by way of example with reference to the accompanying drawings, in which:
FIG. 1 is a block diagram showing a general schematic of an electronic device, according to the invention;
FIG. 2A is a schematic diagram illustrating a cross-sectional view of a haptic device according to the invention;
FIG. 2B is a schematic diagram illustrating a cross-sectional view of a haptic device according to embodiments of the invention;
FIG. 2C is a schematic diagram illustrating a cross-sections view of a haptic device according to embodiments of the invention;
FIG. 3 is a schematic diagram illustrating a perspective view of a section of a haptic device according to embodiments of the invention;
FIG. 4 is a more detailed view of a portion of the haptic device of FIG. 3;
FIG. 5 is a schematic diagram illustrating a perspective view of a section of a composite piezoelectric structure, according to embodiments of the invention; and
FIG. 6 is a schematic view of a haptic device according to embodiments of the present invention;
FIG. 7A is a schematic exploded view of a haptic device according to embodiments of the present invention; and
FIG. 7B is a schematic exploded view of a haptic device according to embodiments of the present invention.

The present disclosure describes embodiments of haptic devices that include haptic feedback actuators that impose haptic effects on a user via a user interface, human-computer interface, or other portions of a user device on which or within which the actuators reside. In particular, the embodiments of the haptic devices described herein can be configured to apply haptic effects to a touch sensitive surface of a user device. The touch sensitive surface, in some embodiments, can be part of a display device that may include both a visual output mechanism and a touch sensitive input mechanism. Thus, haptic feedback can be applied in user devices, such as electronic handheld devices, for providing a rich sensory experience for the user.

In contrast with the use of monolithic piezoelectric actuators, the present disclosure describes use of "composite piezoelectric materials" to provide haptic feedback. Haptic feedback can also be referred to as tactile effect, tactile feedback, haptic effect, force feedback, or vibrotactile feedback. Composite piezoelectric materials may be used to achieve specific characteristics of a haptic feedback device. For instance, mechanical strength, stiffness, damping coefficients, toughness, flexibility, displacement to length ratio, power consumption, actuation force, etc., can be optimized to meet particular electromechanical targets for specific applications. In addition, because of the flexibility characteristics of composite piezoelectric material, the haptic feedback actuators can serve as a viscoelastic suspension for a touch screen, which can be placed on a haptic feedback actuator. By tuning the viscoelastic characteristics, the resonant frequency of the touch screen structure can be adjusted.

Although many of the examples described herein relate to touch screen devices, it should be understood that the present disclosure also encompasses other types of human-computer interfaces involving touch sensitive structures. In addition, other features and advantages will be apparent to one of ordinary skill in the art upon reading and understanding the general principles of the present disclosure. These other features and advantages are intended to be included in the present disclosure as well.

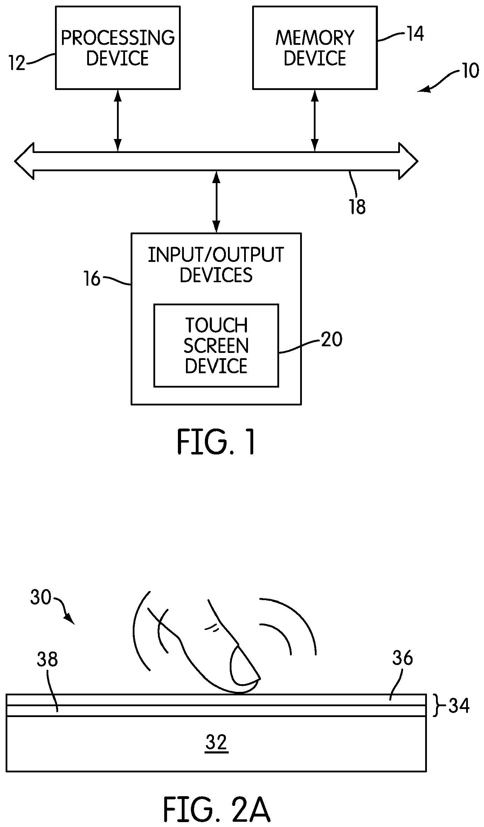

FIG. 1 is a block diagram of an electronic device 10 in accordance with the present invention. More particularly, the electronic device 10 includes a processing device 12, a memory device 14, and input/output devices 16, which are interconnected via a bus 18. Furthermore, the input/output devices 16 include a touch screen device 20 or other human-computer interface device.

The touch screen device 20 may be configured as any suitable human-computer interface or touch/contact surface assembly. The touch screen device 20 may be any touch screen, touch pad, touch sensitive structure, computer monitor, laptop display device, workbook display device, kiosk screen, portable electronic device screen, or other suitable touch sensitive device. The touch screen device 20 may be configured for physical interaction with a user-controlled device, such as a stylus, finger, etc. In some embodiments, the touch screen device 20 may include at least one output device and at least one input device. For example, the touch screen device 20 may include a visual display and a touch sensitive screen superimposed thereon to receive inputs from a user's finger. The touch screen device 20 provides haptic feedback to at least a portion of the electronic device 10, which can be conveyed to a user in contact with the electronic device 10. Particularly, the touch screen device 20 can provide haptic feedback to the touch screen itself to impose a haptic effect when the user in is contact with the screen. The haptic effects can be used to enhance the user experience, and particularly can provide a confirmation to the user that the user has made sufficient contact with the screen to be detected by the touch screen device 20.

The electronic device 10 may be any device, such as a desk top computer, laptop computer, electronic workbook, electronic handheld device (such as a mobile phone, gaming device, personal digital assistant ("PDA"), portable e-mail device, portable Internet access device, calculator, etc.), kiosk (such as an automated teller machine, ticking purchasing machine, etc.), printer, point-of-sale device, game controller, or other electronic device.

The processing device 12 may be a general-purpose or specific-purpose processor or microcontroller for managing or controlling the operations and functions of the electronic device 10. For example, the processing device 12 may be specifically designed as an application-specific integrated circuit ("ASIC") to control output signals to a driver of the input/output devices 16 to provide haptic effects. The processing device 12 may be configured to decide, based on predefined factors, what haptic effects are to be played, the order in which the haptic effects are played, and the magnitude, frequency, duration, and/or other parameters of the haptic effects. The processing device 12 can also be configured to provide streaming motor commands that can be used to drive the haptic actuators for providing a particular haptic effect. In some embodiments, the processing device 12 may actually include a plurality of processors, each configured to perform certain functions within the electronic device 10.

The memory device 14 may include one or more internally fixed storage units, removable storage units, and/or remotely accessible storage units. The various storage units may include any combination of volatile memory and non-volatile memory. The storage units may be configured to store any combination of information, data, instructions, software code, etc. More particularly, the storage devices may include haptic effect profiles, instructions for how the haptic actuation devices of the input/output devices 16 are to be driven, or other information for generating haptic effects.

In addition to the touch screen device 20, the input/output devices 16 may also include specific input mechanisms and output mechanisms. For example, the input mechanisms may include such devices as keyboards, keypads, cursor control devices (e.g., computer mice), or other data entry devices. Output mechanisms may include a computer monitor, virtual reality display device, audio output device, printer, or other peripheral devices. The input/output devices 16 may include mechanisms that are designed to not only receive input from a user and but also provide feedback to the user, such as many examples of touch screen devices. The touch screen device 20 and other input/out devices 16 may include any suitable combination and configuration of buttons, keypads, cursor control devices, touch screen components, stylus-receptive components, or other data entry components. The touch screen device 20 may also include any suitable combination of computer monitors, display screens, touch screen displays, haptic or tactile actuators, haptic effect devices, or other notification devices for providing output to the user.

FIG. 2A illustrates a cross-section of a haptic device 30, which may be a touch screen device, such as the touch screen device 20 illustrated in FIG. 1. As illustrated, the haptic device includes a substrate 32, which may be a touch screen glass plate, or a flexible structure, as discussed in further detail below. A substantially transparent, i.e., at least 40% transparency, composite piezoelectric cell 34 overlays or is located on top of the substrate 32 so that when a user touches what appears to the user to be a touch screen, the user touches the composite piezoelectric cell 34.

As illustrated in FIG. 2A, the composite piezoelectric cell 34 includes layers that have different electromechanical characteristics, including a top composite layer 36, which may be a wide layer that deforms at the micro scale when touched, thereby acting as a sensor, and a bottom composite layer 38, which may act as an actuator. The flexibility of the top layer 36 makes it possible for the haptic effects generated at the bottom layer 38 to be transferred to the human hand interacting with the device. An interdigitated electrode system may be used to detect the touch by the top layer 36, using the direct piezoelectricity effect, and then use the signal generated by the detected touch to in turn provide a signal to actuate the bottom layer 38. In an embodiment, the top composite layer 36 may act as the actuator, and the bottom composite layer 38 may act as the sensor.

Various connectivity patterns may be used to attach the top layer 36 and the bottom layer 38 in order to optimize the electromechanical properties of the system. For example, a pattern that provides a relatively flexible (deformable) medium at the layer acting as the sensor may be chosen, thereby allowing for better touch detection function, while core layers having a more rigid structure, may be used as the layer acting as the actuator.

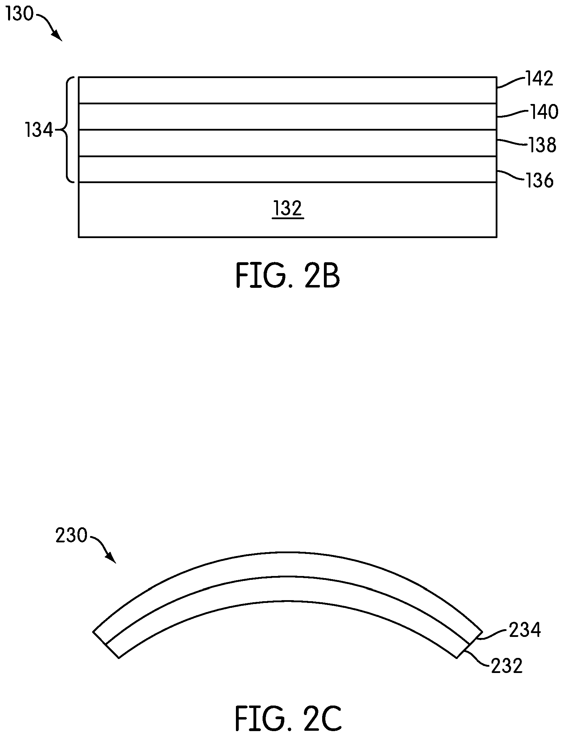

FIG. 2B illustrates an embodiment of a haptic device 130 that includes a substrate 132, like the substrate 32 of FIG. 2A, and a substantially transparent composite piezoelectric cell 134 that overlays or is located on top of the substrate 132 so that when a user touches the top surface of the haptic device 130, the user touches the composite piezoelectric cell 134. In an embodiment, the substrate 132 may be a display configured to display an image through the piezoelectric cell 134, and due to the transparency of the piezoelectric cell 134, the user may think the display itself is being touched. As illustrated in FIG. 2B, the substantially transparent composite piezoelectric cell 134 includes a first layer 136, overlaying the substrate 132, a second layer 138 overlaying the first layer 136, a third layer 140 overlaying the second layer 138, and a fourth layer 142 overlaying the third layer 140. The illustrated embodiment is not intended to be limiting in any way and more or less layers than the four illustrated layers may be used, e.g., 3, 5, 6, etc.

In an embodiment, one of the four layers, such as the fourth layer 142, may be configured to act as a sensor, and the rest of the layers, i.e., the first layer 136, the second layer 138, and the third layer 140 may be configured to act as actuators. An interdigitated electrode system may be used to detect the touch by the layer acting as the sensor, using the direct piezoelectricity effect, and then use the signal generated by the detected touch to in turn provide independent signals to actuate the layers acting as actuators so that a desired haptic effect may be generated. For example, in an embodiment, the signals may be provided to all three layers substantially simultaneously to strengthen a haptic effect, as compared to the effect generated by a single layer acting as an actuator, if desired.

FIG. 2C illustrates an embodiment in which a haptic device 230 that includes a substrate 232 and a substantially transparent piezoelectric cell 234, similar to the haptic devices 30, 130 illustrated in FIGs. 2A and 2B, is flexible. By flexible it is meant that gross deformations are possible with the device as opposed to slight flexures that occur in current touch screens. The flexible substantially transparent piezoelectric cell 234 and substrate 232 may be bendable, foldable, or rollable, for example. A rollable structure is where a bendable structure is capable of bending back on itself to form a roll.

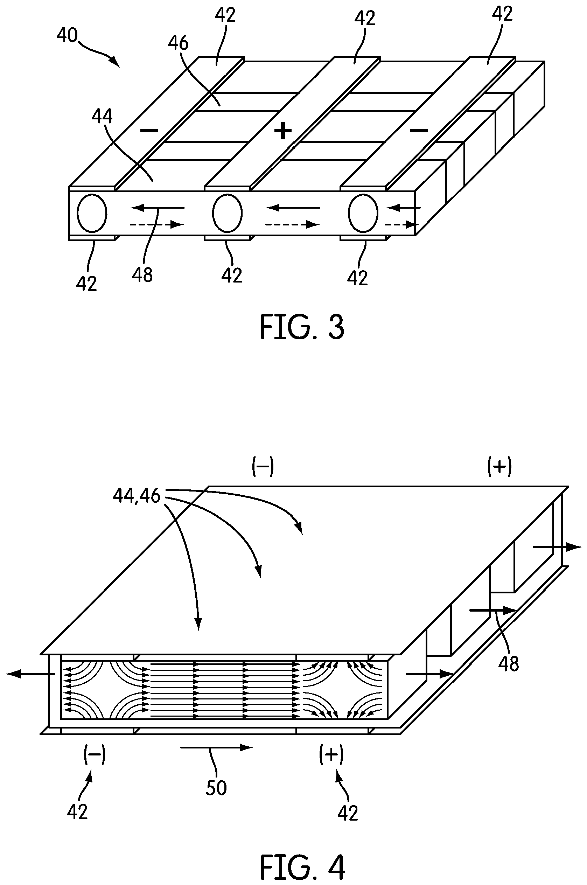

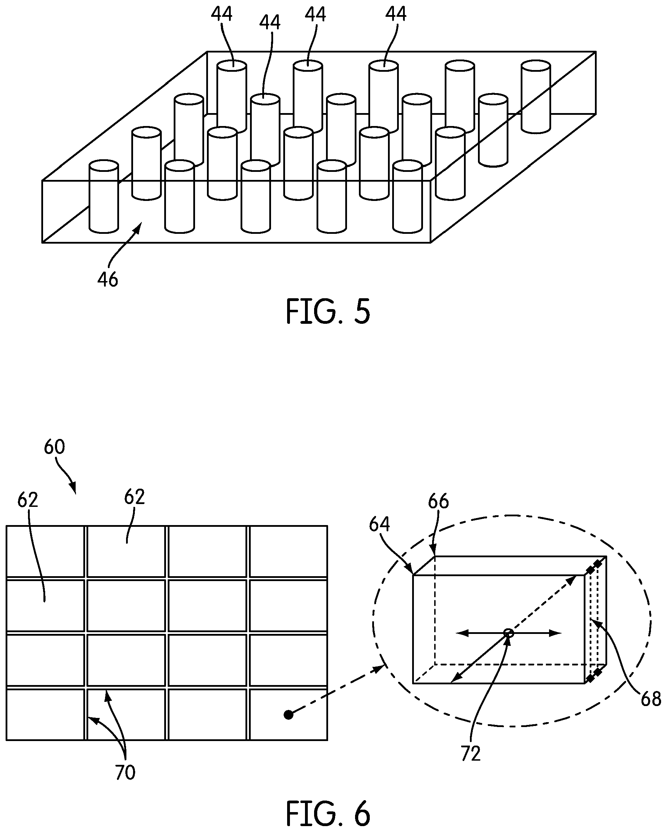

As illustrated in the embodiments of FIGs. 3 and 4, the layer configured to act as a sensor and the layer configured to act as an actuator may be combined into one single module in the form of a composite piezoelectric actuator/sensor cell. FIGs. 3 and 4 illustrate the cross section of a composite piezoelectric actuator/sensor cell 40 with its associated electrodes 42. The composite piezoelectric cell 40 includes an array of piezoceramic fibers 44 in structural adhesive 46, such as an epoxy material, a schematic of an embodiment of which is illustrated in FIG. 5. In an embodiment, the fibers may have a rectangular, instead of the illustrated circular, cross-section. As illustrated, each of the electrodes 42 shown may be used to send an individual control signal so that each patch of fibers 44 embedded in the structural adhesive 46 shown between two consecutive electrodes 42 can be actuated, thereby creating a localized haptic effect at the corresponding location. Arrows 48 represent how the polarized piezoceramic material expands or contracts in response to an applied electric field, and arrow 50 represents the piezoceramic polarization created by the electrodes 42.

Similarly, if the voltage across each of the electrodes 42 is monitored and measured while the user is interacting with the device 40, the location of the interaction (touch) can be determined based on the piezoelectricity effect occurring on each patch of the piezo fibers 44 embedded in the device 40. A multiplexer, for example, may be used to command individual control signals and measure the sensory signal.

In an embodiment, the device 40 may be fabricated with a flexible mechanical structure, thereby allowing the device 40 to conform to irregular surfaces in industrial applications. As discussed above, by flexible it is meant that gross deformations are possible with the device as opposed to slight flexures that occur in current touch screens. The flexible mechanical structure and substrate can be bendable, foldable, or rollable, for example.

FIG. 6 illustrates an embodiment of a haptic device 60 that includes a grid of rectangular composite piezoelectric cells 62 that are configured to function as a touch sensor and provide isolated local haptic feedback at the same time. Although the illustrated embodiment illustrates a grid of rectangular cells 62 arranged in a 4x4 matrix, more or less cells 62 and other non-rectangular geometries may be used. The illustrated embodiment is not intended to be limiting in any way. For example, the illustrated matrix of cells 62 could be part of a larger grid of cells that function as a touch screen or touch pad of a handheld device, for example. Each of the illustrated cells 62 in FIG. 6 is a rectangular strip of transparent composite piezoelectric material that can provide haptic effects in either lateral or normal directions (relative to the plane of the haptic device, as represented by arrows 72) depending on the mounting configuration.

As illustrated in FIG. 6, electrode layers 64, 66 are located on top and bottom of the shown grid, and electrode pathways 68 are provided in a way that each cell 62 can be actuated independent from the other cells 62. Localized isolated haptic effects can be achieved by sending control drive signals to each individual cell 62. The electrode layers 64, 66 are substantially transparent. In an embodiment, the electrode layers 64, 66 may have composite piezo material embedded within the layers.

As shown in FIG. 6, the haptic device 60 includes a vibration isolator 70 in between adjacent cells 62. In an embodiment, the vibration isolator 70 includes a transparent polymer-based structure that is embedded between the cells 62 to avoid vibration transfer between the cells 62. In an embodiment, the vibration isolator 70 is in the form of a gap between adjacent cells 62.

By taking advantage of the sensor functionality of composite piezoelectric materials, each of the cells 62 can serve as a pressure sensor as well as an actuator, and can be capable of detecting a touch within the boundaries of its area. Assuming that the haptic device 60 illustrated acts as a touch sensor, the resolution of the sensing function may be limited to the size of each cell 62. As opposed to traditional touch screen technology, there is no need to provide external voltage for the sensor functionality of the composite piezoelectric cell 62 to work. Instead, upon deformation/pressure applied on top of each cell 62, the composite piezo material associated with that cell 62 generates a voltage difference across its corresponding electrodes 64, 66, which may be used as a measure of the magnitude of applied pressure with a high resolution.

Various connectivity patterns may be used for the composite piezoelectric cells 62 in order to optimize the electromechanical properties of the device 60. For example, a relatively flexible (deformable) yet mechanically robust and rugged touch sensor/actuator can be achieved, which may allow for better integration and improved lifetime. Such solution is of potential to be used in cases where it is desirable for the device 60 to conform to surfaces with non-flat geometry. Using specific deposition, coating, and cofiring techniques, the haptic device 60 described above may be made in any shape, with the potential to become extremely thin.

Although it may be difficult to make pieces of transparent piezo that are larger than a few centimeters long and can, for example, cover the surface of a typical handheld devices, by providing an array of cells 62 having composite piezo material with small fibers of transparent single crystal or ceramic piezo embedded in a matrix of a polymer, larger composite piezo sensor/actuator systems may be created. In an embodiment, the piezo material may be a macro fiber composite manufactured and supplied, for example, by Smart Material Corporation based in Sarasota, Florida.

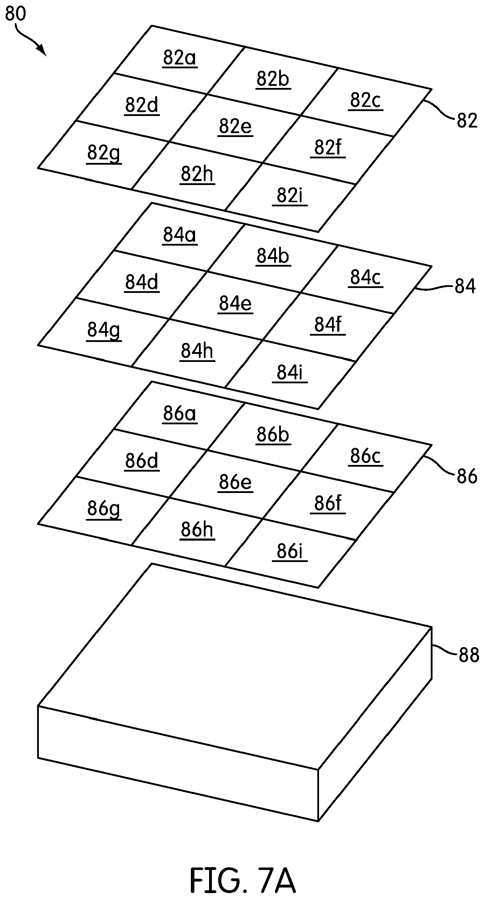

FIG. 7A illustrates an embodiment of a haptic device 80 that includes a plurality of substantially transparent piezoelectric layers that each includes an array of substantially transparent piezoelectric cells. For example, a first layer 82 may include a 3x3 array of cells 82a-i, a second layer 84 may include a 3x3 array of cells 84a-i, and a third layer 86 may include a 3x3 array of cells 84a-i. Although three layers are illustrated, only two layers, or additional layers may be included.

The cells 82a-i, 84a-i, and 86a-i may be substantially aligned with each other. Similar to the embodiment illustrated in FIG. 2B, one of the layers, such as the first layer 82 may be configured to act as a sensor, and the other layers, i.e., the second layer 84 and the third layer 86, may be configured to act as actuators. In an embodiment, each layer, and each cell within each layer may operate independent from each other so that the desired haptic effect may be generated in response to a sensed touch. For example, the layer that is configured to be the sensor will sense the touch an generate a signal to the interdigitated electrode system, using the direct piezoelectricity effect, and then use the signal generated by the detected touch to in turn provide a signal to actuate any of the cells, or any combination of the cells, that are part of the layers that are configured to be actuated. More specifically, in a non-limiting example, a user may touch an area that generally corresponds to the cell 82a of the first layer 82, which may be configured to act as the sensor, and in response, a desired haptic effect may be generated by the cell 84a, or a combination of the cell 84a and 86a, or a desired haptic effect may be generated by the cell 84i, or a combination of the cell 84i and 86e. The substantially transparent piezoelectric layers 82, 84, 86 may be supported by a substrate 88, which may be a display that is configured to display an image that may be viewable through the substantially transparent piezoelectric layers 82, 84, 86.

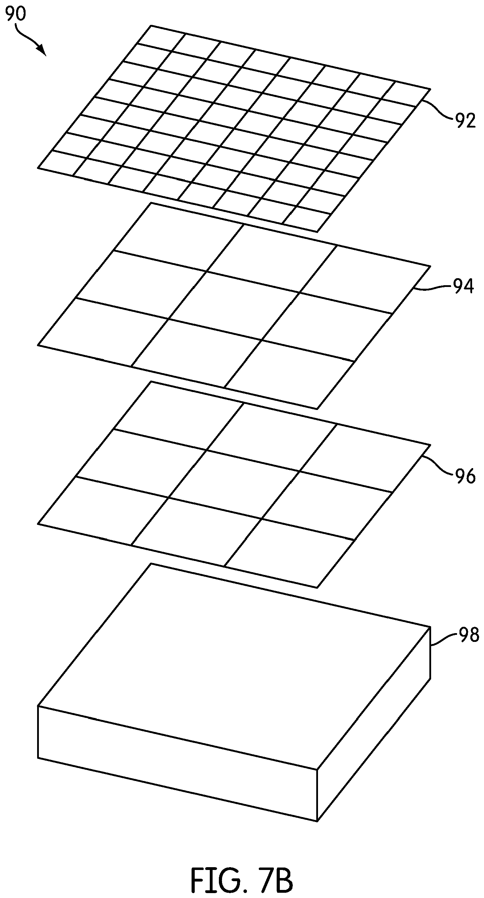

FIG. 7B illustrates a haptic device 90 that includes a plurality of substantially transparent piezoelectric layers that each includes an array of substantially transparent piezoelectric cells. For example, a first layer 92 may include an 8x8 array of cells, a second layer 94 may include a 3x3 array of cells, and a third layer 96 may include a 3x3 array of cells. The substantially transparent piezoelectric layers 92, 94, 96 may be supported by a substrate 98, which may be a display that is configured to display an image that may be viewable through the substantially transparent piezoelectric layers 92, 94, 96. Although three layers are illustrated, the haptic device 90 may include only two layers or the haptic device 90 may include more than three layers. The illustrated embodiment is not intended to be limiting in any way. Also, each of the layers may have a different number of cells in the array. For example, in an embodiment, the third layer may include a 2x2 array of cells instead of a 3x3 array of cells, if desired.

In an embodiment, the first layer 92 may be configured to act as the sensor, and additional (smaller) cells may be used to increase the resolution of the sensor. Similarly, in an embodiment, the second layer 94 and the third layer 96 may include fewer (larger) cells to increase the haptic effect that can be provided by each cell. A multitude of combinations are contemplated and the illustrated embodiment is not intended to be limiting in any way.

In an embodiment, the layers disclosed herein that are configured to act as sensors, i.e., sensor layers, may be configured to recognize touches to the haptic devices, as well as the position and magnitude of the touches on the haptic devices. For example, the sensor layers may be configured to measure displacement of the layers when the layers are touched, which can be used to derive the applied pressure to the layers. The signals corresponding to the touches (i.e., displacement and/or pressure) may be sent to a processing device, such as the processing device 12 discussed above, and the processing device may interpret the touches and in response generate the desired haptic effect. Through the sensor layer and processing device, the haptic device may be configured to sense multi-touch contacts and distinguish multiple touches that occur at substantially the same time.

The haptic devices according to embodiments of the present invention may be configured to display images for the user to interact with, such as keys, dials, menu lists, etc., that may be viewed through the substantially transparent piezoelectric cells, or may be configured as, for example, a touchpad with minimal or no images. In an embodiment, the haptic device may be configured to sense two separate touches to the device at substantially the same time. In one embodiment, a dynamic haptic effect based on a number of possible factors associated with the two separate touches may be generated. For example, the haptic effect may be based, at least in part, by the distance between the two touches, the direction of motion of the two touches, the number of touches (e.g., if there are more than two touches), the position of the touches, the function being initiated by the touches, the amount of pressure being applied via each touch, etc.

In an embodiment, a dynamic haptic effect may be calculated by the processing device based the position and number of touches, and based on any number of other factors such as the factors disclosed above (e.g., distance between touches, direction of motion of touches, etc.). The haptic effect is considered to be dynamic in that one or more parameters such as amplitude, vibration, frequency, etc. are varied over time. The dynamic nature of the haptic effect provides additional information to the user in contrast to static haptic effects. The need to provide additional information increases as two or more generally simultaneously touches are sensed on a multi-touch device. In one embodiment, multiple dynamic haptic effects may be calculated, one for each touch, so that each contact object (e.g., each finger) may experience a different haptic effect rather than a single dynamic haptic effect that is applied to the entire haptic device. After the dynamic haptic effect has been calculated by the processing device, the dynamic haptic effect may be output to the layer(s) of the substantially transparent composite piezoelectric cell that are configured to act as actuators so that the dynamic haptic effect may be implemented.

In operation, dynamic haptic effects may be generated in response to multi-touch contacts to enhance the functionality and usability of the haptic device. For example, when the multi-touch contacts are two or more fingers, a user may be able to move fingers apart while touching the haptic device in order to zoom in on a displayed image. In response, a dynamic haptic effect can be generated that increases in amplitude or frequency to communicate the sensation of a growing or increasing virtual window or object size and/or volume. The action of bringing the fingers back together can result in an equal and opposite decreasing amplitude or frequency to communicate the sensation of a shrinking or decreasing virtual window or object size and/or volume.

In another example, two or more fingers may be moved apart for the purpose of moving through a displayed list of contacts, text, or menu items and in response a dynamic haptic effect of increasing amplitude or frequency may be generated that is based on the distance between the finger points. The further apart the user's fingers are, the greater the amplitude or frequency of the haptic effects would be in order to communicate the sensation of increasing speed or movement through the list of contacts or menu items. The action of bringing the fingers back together would result in an equal and opposite decreasing amplitude, or frequency to communicate the sensation of a decreasing speed or movement through the list of contacts or menu items.

Further, two or more fingers can make a rotating gesture equivalent to turning a virtual knob displayed on a touch screen. In response, dynamic haptic effects can be generated as the virtual knob is turned to simulate those sensations felt in turning a mechanical knob such as detents and barriers. Other dynamic effects can be generated that are not typically associated with a rotary knob but provide information such as scroll-rate control, end-of-list/top-of-list notifications, etc.

In another embodiment, two or more fingers may set a boundary box (selection area) that allows the user to interact with all virtual grasped items contained in the bounded box. While sliding the bounded box, dynamic haptic effects may generate a sliding feeling and can vary depending on the speed of the dragging or how far the box is being dragged. Further, the interaction of resizing the items by increasing or decreasing the distance between two fingers may generate an equivalent dynamic haptic effect of increasing or decreasing amplitude or frequency, or a haptic effect of consistent amplitude and frequency that communicates the action of relative increasing or decreasing object sizes. Further, the interaction of rotating the grasped items by rotating fingers clockwise or counter-clockwise may generate an equivalent dynamic haptic effect of increasing or decreasing haptic amplitude or frequency, or a haptic effect of consistent amplitude and frequency that communicates the action of rotating the object(s) away from their initial starting location or virtual setting. Further, the interaction of dragging the items by moving the fingers across the screen may generate an equivalent dynamic haptic effect of increasing or decreasing haptic amplitude or frequency, or a haptic effect of consistent amplitude and frequency that communicates the action of physically dragging the object(s) away from their initial starting location or virtual setting.

In another embodiment, multiple users may apply multi-touch contacts to the haptic device and each user may need different haptic effects based on the specific application or interaction they are making at any given moment in time. Further, a single, multi-hand user may need different haptic effects for each hand based on the specific actions each hand is making at any given moment. For example, one hand may be using two fingers to grab or pinch a virtual object while the other hand may be using two fingers to manipulate the virtual object or to zoom in/out or even scroll through a separate menu list. Both actions may be happening simultaneously on the same surface and benefit from different dynamic haptic effects being generated at each hand.

Embodiments of the present invention may be used as the actuation unit to enable haptic effects in various electronic devices, such as touch screen handheld devices (mobile devices, PDA, and navigation systems), automotive applications, gaming consoles, etc.

The embodiments described herein represent a number of possible implementations and examples and are not intended to necessarily limit the present disclosure to any specific embodiments. Instead, various modifications can be made to these embodiments as would be understood by one of ordinary skill in the art. Any such modifications are intended to be included within the scope of the present disclosure.

Embodiments of the present invention have been described with particular reference to the examples illustrated. While specific examples are shown in the drawings and are herein described in detail, it should be understood, however, that the drawings and detailed description are not intended to limit the invention to the particular form disclosed. It will be appreciated that variations and modifications may be made to the examples described within the scope of the present invention.

## Claims

1. A haptic device (30; 130; 230), comprising:
a substrate (32; 132; 232); and
a substantially transparent composite piezoelectric cell (34; 134; 234) overlaying the substrate, the piezoelectric cell comprising
a sensor piezoelectric layer (36; 142) configured to generate a first signal when the sensor piezoelectric layer is deformed, and
an actuator piezoelectric layer (38; 136, 138, 140) configured to provide a haptic effect upon receipt of a second signal that is based on the first signal, wherein the sensor piezoelectric layer overlays the actuator piezoelectric layer or the actuator piezoelectric layer overlays the sensor piezoelectric layer.

2. The haptic device according to claim 1, wherein the sensor piezoelectric layer overlays the actuator piezoelectric layer.

3. The haptic device according to claim 1 or 2, wherein the substrate is configured to display an image, and wherein the image is viewable through the substantially transparent composite piezoelectric cell.

4. The haptic device according to claim 1, 2 or 3, further comprising a plurality of substantially transparent composite piezoelectric cells overlaying the substrate.

5. The haptic device according to claim 4, further comprising a vibration isolator located between adjacent piezoelectric cells and configured to isolate vibration in one of the piezoelectric cells from other piezoelectric cells.

6. The haptic device according to any one of the preceding claims, wherein the substrate and the substantially transparent composite piezoelectric cell are bendable, foldable or rollable.

## Patentansprüche

1. Haptische Vorrichtung (30; 130; 230), die umfasst:
ein Substrat (32; 132; 232); und
eine im Wesentlichen durchsichtige piezoelektrische Verbundzelle (34; 134; 234), die das Substrat überdeckt, wobei die piezoelektrische Zelle umfasst
eine piezoelektrische Sensorschicht (36; 142), die konfiguriert wird, ein erstes Signal zu erzeugen, wenn die piezoelektrische Sensorschicht verformt wird, und
eine piezoelektrische Stellantriebsschicht (38; 136, 138, 140), die konfiguriert wird, eine haptische Auswirkung bei Empfang eines zweiten Signals bereitzustellen, das auf dem ersten Signal beruht, wobei die piezoelektrische Sensorschicht die piezoelektrische Stellantriebsschicht überdeckt oder die piezoelektrische Stellantriebsschicht die piezoelektrische Sensorschicht überdeckt.

2. Haptische Vorrichtung nach Anspruch 1, wobei die piezoelektrische Sensorschicht die piezoelektrische Stellantriebsschicht überdeckt.

3. Haptische Vorrichtung nach Anspruch 1 oder 2, wobei das Substrat konfiguriert wird, ein Bild anzuzeigen, und wobei das Bild durch die im Wesentlichen durchsichtige piezoelektrische Verbundzelle sichtbar ist.

4. Haptische Vorrichtung nach Anspruch 1, 2 oder 3, die des Weiteren eine Vielzahl von im Wesentlichen durchsichtigen piezoelektrischen Verbundzellen umfasst, die das Substrat überdecken.

5. Haptische Vorrichtung nach Anspruch 4, die des Weiteren einen Schwingungsisolator umfasst, der zwischen benachbarten piezoelektrischen Zellen angeordnet und konfiguriert wird, Schwingungen von anderen piezoelektrischen Zellen in einer der piezoelektrischen Zellen zu isolieren.

6. Haptische Vorrichtung nach einem der vorhergehenden Ansprüche, wobei das Substrat und die im Wesentlichen durchsichtige piezoelektrische Verbundzelle biegbar, faltbar oder rollbar sind.

## Revendications

1. Dispositif haptique (30 ; 130 ; 230), comprenant :
un substrat (32 ; 132 ; 232) ; et
une cellule piézoélectrique composite pratiquement transparente (34 ; 134 ; 234) recouvrant le substrat, la cellule piézoélectrique comprenant
une couche piézoélectrique de capteur (36 ; 142) conçue pour générer un premier signal lorsque la couche piézoélectrique de capteur est déformée, et
une couche piézoélectrique d'actionneur (38 ; 136, 138, 140) conçue pour produire un effet haptique lors de la réception d'un second signal qui est basé sur le premier signal, ladite couche piézoélectrique de capteur recouvrant la couche piézoélectrique d'actionneur ou la couche piézoélectrique d'actionneur recouvrant la couche piézoélectrique de capteur.

2. Dispositif haptique selon la revendication 1, ladite couche piézoélectrique de capteur recouvrant la couche piézoélectrique d'actionneur.

3. Dispositif haptique selon la revendication 1 ou 2, ledit substrat étant conçu pour afficher une image, et ladite image étant visualisable à travers la cellule piézoélectrique composite pratiquement transparente.

4. Dispositif haptique selon la revendication 1, 2 ou 3, comprenant en outre une pluralité de cellules piézoélectriques composites pratiquement transparentes recouvrant le substrat.

5. Dispositif haptique selon la revendication 4, comprenant en outre un isolateur de vibrations situé entre des cellules piézoélectriques adjacentes et conçu pour isoler des vibrations dans l'une des cellules piézoélectriques par rapport aux autres cellules piézoélectriques.

6. Dispositif haptique selon l'une quelconque des revendications précédentes, ledit substrat et ladite cellule piézoélectrique composite pratiquement transparente étant cintrable, pliable ou enroulable.
